# EUROPÄISCHE PATENTANMELDUNG

(11) **EP 1 783 867 A2**
(43) Veröffentlichungstag der Anmeldung: **09.05.2007**
(21) Anmeldenummer: 06450159.6
(22) Anmeldetag: 07.11.2006
(51) Int. Cl.: H01R 12/12

(54) **Elektrische Verbindung zwischen einem MID und einem Leitungskabel**

(30) Priorität: 07.11.2005 AT 18062005
(71) Anmelder: I & T Innovation Technology Entwicklungs- und Holding Aktiengesellschaft, 7011 Siegendorf (AT)
(72) Erfinder: Ziegler, Wolfgang, 76307 Karlsbad (DE)
(74) Vertreter: Wildhack, Helmut

(57) **Zusammenfassung**

Die Erfindung betrifft ein Verfahren zum Herstellen einer elektrischen Verbindung zwischen einem Kabel (1) mit einem oder einer Vielzahl von elektrischen Leitern (1.1) und einer Schaltung (2) auf einem dreidimensionalen, insbesondere spritzgegossenen Schaltungsträger (3), umfassend die folgenden Schritte:
- auf dem Schaltungsträger (3) wird ein Kontaktelement (4) ausgebildet, welches eine erhabene, metallisierte Oberfläche (4.1) aufweist, die mit der Schaltung (3) elektrisch verbunden ist;
- in dem Kabel (1) wird eine Aussparung (5) in Form eines Durchgangsloches vorgesehen, wobei
- die Aussparung (5) derart in das Kabel (1) eingebracht wird, dass sie wenigstens einen Leiter (1.1) in dem Kabel (1) vollständig durchdringt und dadurch eine leitende Oberfläche des Leiters (1.1) freilegt;
- das Kabel (1) wird derart mit seiner Aussparung auf das Kontaktelement (4) geschoben, dass die freigelegte leitende Oberfläche des Leiters in einen elektrisch leitenden Kontakt mit der metallisierten Oberfläche (4.1) des Kontaktelementes (4) gelangt.

Des weiteren betrifft die vorliegende Erfindung eine Baugruppe aus einem dreidimensionalen Schaltungsträger und einem Kabel mit einer entsprechenden elektrisch leitenden Verbindung zwischen den Bauteilen.

## Beschreibung

Die Erfindung betrifft ein Verfahren zum Herstellen einer elektrischen Verbindung zwischen einem dreidimensionalen, insbesondere spritzgegossenen Schaltungsträger, kurz 3D-MID (Molded Interconnect Device), und einem Kabel mit einem oder einer Vielzahl von elektrischen Leitern. Des weiteren betrifft die vorliegende Erfindung eine Baugruppe aus einem solchen dreidimensionalen spritzgegossenen Schaltungsträger und einem Kabel mit wenigstens einem elektrischen Leiter, wobei die Schaltung des dreidimensionalen spritzgegossenen Schaltungsträgers und der elektrische Leiter elektrisch miteinander verbunden sind.

Die Integration von elektrischen und mechanischen Funktionen auf dreidimensionalen spritzgegossenen Schaltungsträgern ist seit einigen Jahren bekannt. Dabei werden Metallschichten auf Ein- oder Zweikomponentenkunststoffteilen selektiv aufgebracht, wobei die thermoplastischen Schaltungsträger beliebig geformt sein können.

MID ermöglicht eine Rationalisierung in der Elektro- und Elektronikproduktion und bietet gleichzeitig eine verbesserte Gestaltungsfreiheit. Insbesondere ist durch diese Technik die Ausbildung von dreidimensionalen Schaltungen möglich.

MIDs können durch verschiedene Verfahren hergestellt werden. Dabei unterscheidet man im wesentlichen zwischen dem Zweikomponentenspritzguss, dem Einkomponentenspritzguss und dem Folienhinterspritzen (auch In-Mold-Decoration, IMD). Beim Einkomponentenspritzguss kann man das Herstellungsverfahren zusätzlich in die Kategorien Heißprägen, Laserdirektstrukturierung und Maskenbelichtungsverfahren unterteilen. Das Folienhinterspritzen ist als auch Primertechnologie bekannt, da die Schaltbilder mit Hilfe eines speziellen Primers auf die Folie aufgebracht werden.

Die vorliegende Erfindung betrifft das elektrische Verbinden eines beliebig hergestellten dreidimensionalen, insbesondere spritzgegossenen Schaltungsträgers (MID), insbesondere eines Schaltungsträgers, welcher gemäß einem der genannten Verfahren hergestellt wird.

Insbesondere in der Automobilindustrie, jedoch auch auf anderen Gebieten, ist es zum sinnvollen Einsatz von MID notwendig, die Schaltung beziehungsweise Schaltungen auf einem Schaltungsträger mit elektrisch leitenden Kabeln zu verbinden. Insbesondere kommt eine Verbindung mit flexiblen Flachkabeln, sogenannten FFCs (Flat Flexible Cable) in Betracht, welche heutzutage verbreitet Anwendung in Automobilen finden. Hierzu wurde bereits vorgeschlagen, freigelegte Leiterenden des FFC mittels Lötverbindungen mit der Schaltung auf dem spritzgegossenen Schaltungsträger zu verbinden. Als nachteilig ist dabei anzusehen, dass durch das Erhitzen des Lots der Wärmeeintrag in den Schaltungsträger im Hinblick auf dessen Werkstoff schnell zu groß wird und eine Automatisierung des Verbindungsvorgangs schwierig ist.

Der Erfindung liegt die Aufgabe zugrunde, ein Verfahren zum Herstellen einer elektrischen Verbindung zwischen einem dreidimensionalen, insbesondere spritzgegossenen Schaltungsträger und einem Kabel mit wenigstens einem elektrischen Leiter sowie eine Baugruppe aus einem MID und einem entsprechenden Kabel darzustellen, bei welchen die Verbindung im wesentlichen frei von einem Wärmeeintrag in den Schaltungsträger und insbesondere automatisiert erfolgen kann. Dabei soll die Verbindung zuverlässig und dauerhaft erfolgen.

Die erfindungsgemäße Aufgabe wird durch ein Verfahren mit den Merkmalen von Anspruch 1 und eine Baugruppe gemäß dem Anspruch 9 gelöst. Die abhängigen Ansprüche beschreiben vorteilhafte und besonders zweckmäßige Ausgestaltungen der Erfindung.

Das erfindungsgemäße Verfahren dient dem Herstellen einer elektrischen Verbindung zwischen einem Kabel mit wenigstens einem elektrischen Leiter, insbesondere mit einer Vielzahl von elektrischen Leitern, und der Schaltung auf einem dreidimensionalen, insbesondere spritzgegossenen Schaltungsträger, das heißt einem sogenannten MID. Der oder die Leiter des Kabels können dabei beliebige Querschnitte aufweisen, beispielsweise einen kreisrunden oder ovalen Querschnitt bei sogenannten Rundleitern, oder einen eckigen Querschnitt, beispielsweise quadratischen oder rechteckigen Querschnitt bei sogenannten Flachleitern. Als Kabel kommt insbesondere ein flexibler, extrudierter Flachleiter in Betracht, welcher aus folienartigen Kupferbändern besteht, die mittels einer dünnen klebstofffreien Kunststoffschicht elektrisch isoliert und miteinander zu einem Band verbunden sind.

Unter Schaltung auf dem MID im Sinne der vorliegenden Erfindung sind sowohl komplexe, insbesondere dreidimensionale Schaltungen als auch einfache Schaltungen, beispielsweise in Form einer einfachen elektrischen Leitung zu verstehen.

Als Materialien für das dreidimensionale, insbesondere spritzgegossene Bauteil kommt beispielsweise Durethan_{®}, Pocan_{®}, Novodur_{®}, Bayblend_{®}, Makrolon_{®}, Makrofol_{®} oder VESTODUR_{®} der Firma Bayer in Betracht. Selbstverständlich können andere Werkstoffe, im allgemeinen Polymere oder Polyamide, die beispielsweise glasfaserverstärkt sein können, verwendet werden. Erfindungsgemäß wird auf dem Schaltungsträger ein Kontaktelement ausgebildet, welches eine erhabene, metallisierte Oberfläche aufweist, die elektrisch mit der Schaltung auf dem Schaltungsträger verbunden ist. Das Kontaktelement, welches beispielsweise kalottenförmig ist, bietet somit eine von dem Schaltungsträger abstehende, elektrisch leitende Oberfläche, an welche der oder die Leiter des Kabels angeschlossen werden können.

In dem Kabel wird erfindungsgemäß eine Aussparung vorgesehen, beispielsweise eine Ausstanzung, wobei die Aussparung derart in dem Kabel, welches insbesondere als FFC ausgebildet ist, eingebracht wird, dass eine leitende Oberfläche von wenigstens einem Leiter in dem Kabel freigelegt wird. Die freigelegte Oberfläche kann beispielsweise ein Leiterende sein oder auch ein mittlerer Bereich eines im Kabel lang ausgestreckten Leiters. Erfindungsgemäß ist die Aussparung als Durchgangsloch beziehungsweise als Durchgangsöffnung durch den Leiter ausgeführt, so dass sie den Leiter vollständig durchdringt, und sie wird insbesondere entlang ihres gesamten äußeren Umfangs von der freigelegten leitenden Oberfläche des Leiters umschlossen.

Beispielsweise ist der Leiter als Flachleiter ausgebildet und weist eine Breite auf, welche größer ist als die Ausdehnung der Aussparung in Richtung dieser Breite. Die Aussparung ist demnach vollständig innerhalb des Leiterquerschnittes positioniert.

Gemäß dem erfindungsgemäßen Verfahren wird das Kabel derart mit seiner Aussparung auf das erhabene Kontaktelement geschoben, dass die freigelegte leitende Oberfläche des Leiters oder die Oberflächen der Leiter in einen elektrisch leitenden Kontakt mit der metallisierten Oberfläche des Kontaktelementes gelangt/gelangen. Selbstverständlich können auch eine Vielzahl von Kontaktelementen vorgesehen sein, aus welcher jedes einzelne Kontaktelement insbesondere einer einzelnen freigelegten leitenden Oberfläche von jeweils einem Leiter in dem Kabel zugeordnet wird. Hierfür kann eine entsprechend große Aussparung oder eine Vielzahl von Aussparungen in dem Kabel eingebracht werden. Insbesondere wird für jedes Kontaktelement je eine Aussparung in dem Kabel eingebracht, wobei die verschiedenen Aussparungen in Längsrichtung des Kabels versetzt zueinander angeordnet sein können, um die Struktur des Kabels weniger zu schwächen. Die Leiter in dem Kabel können dabei in Längsrichtung nebeneinander positioniert sein.

Um im Praxiseinsatz auch bei stark wechselnden Temperaturen stets einen optimalen elektrischen Kontakt zwischen dem Leiter und dem Kontaktelement sicherzustellen, wird vorteilhaft zwischen der freigelegten leitenden Oberfläche des Leiters und der metallisierten Oberfläche des Kontaktelementes ein Presssitz hergestellt. Insbesondere wird das Kabel zumindest in dem Bereich seiner Aussparung, insbesondere in dem ausgestanzten Bereich, derart gegen den Bereich des Schaltungsträgers mit dem Kontaktelement gedrückt, dass ein Linienkontakt oder Flächenkontakt zwischen dem Leiter und der metallisierten Oberfläche des Kontaktelementes ausgebildet wird.

Der Presssitz kann vorteilhaft zumindest vorübergehend mit einer solchen Presskraft hergestellt werden, dass eine Kaltverschweißung zwischen der freigelegten Oberfläche des Leiters und der metallisierten Oberfläche des Kontaktelementes erzeugt wird. Im Gegensatz zu einer Verlötung ergibt sich dabei kein schädlicher Wärmeeintrag in den Schaltungsträger, da die Wärmeentwicklung vergleichsweise gering ist, und die maximal auftretende Temperatur insbesondere unterhalb von 100° C, 50° C oder 30° C gehalten wird.

Die Aussparung und/oder das Kontaktelement kann mit wenigstens einer Auflaufschräge versehen werden. Die Auflaufschräge bewirkt eine Zentrierung und/oder ein automatisches Anpressen zwischen der freigelegten leitenden Oberfläche des Leiters und einem vorgegebenen Kontaktbereich der metallisierten Oberfläche des Kontaktelementes beim Aufschieben des Kabels auf das Kontaktelement. Dabei ist im Sinne der vorliegenden Erfindung der Begriff des Aufschiebens des Kabels umfassend zu verstehen und soll sowohl das ortsfeste Halten des Kontaktelementes und das Bewegen des Kabels relativ zu diesem als auch das stationäre Halten des Kabels und das relative Bewegen des Kontaktelementes zu diesem oder das Bewegen beider Bauteile umfassen.

Das Kontaktelement kann beispielsweise kegelförmig ausgebildet sein und somit eine umlaufende Auflaufschräge aufweisen. Die Aussparung kann dabei komplementär zu dem Kontaktelement ausgebildet sein, das heißt einen kreisrunden Querschnitt aufweisen. Durch Aufsetzen und Andrücken des Kabels mit seiner Aussparung auf das Kontaktelement wird somit der Presssitz ausgebildet. Um einen punkt- oder linienförmigen Kontaktbereich zwischen den beiden Bauteilen zu erzeugen, in welchem vorteilhaft ein derart hoher Druck entsteht, dass eine Kaltverschweißung stattfindet, kann auch das Kontaktelement kegelförmig und die Aussparung mit einem eckigen Querschnitt, beispielsweise einem quadratischen oder rechteckigen Querschnitt, versehen werden. Alternativ ist es möglich, das Kontaktelement mit einem eckigen Außenumfang, beispielsweise in einer Pyramidenform oder allgemein einem Vieleck, auszubilden und die Aussparung mit einem kreisrunden oder elektrischen Querschnitt zu versehen. Dabei kann der Querschnitt sowohl des Kontaktelementes als auch der Aussparung über seiner/ihrer Tiefe variieren, wobei sich die zuvor beschriebene Paarung von Formen insbesondere auf jene Bereiche der Aussparung und des Kontaktelementes bezieht, welche nach dem Zusammenstecken in einem Kontakt miteinander stehen.

Vorteilhaft weist der Schaltungsträger wenigstens ein zusätzliches Verbindungselement auf, mittels welchem das Kabel form- und/oder kraftschlüssig am Schaltungsträger befestigbar ist. Beispielsweise kann der elektrische Kontakt zwischen dem Kontaktelement und dem Leiter an einer Position hergestellt werden, welche von dem Schaltungsträger weitgehend oder vollständig umschlossen wird. Insbesondere ist der Schaltungsträger mehrteilig ausgebildet, wobei das Umschließen des Kontaktbereiches durch Zusammensetzen der verschiedenen Teile des Schaltungsträgers erfolgt. Insbesondere kann der Schaltungsträger genau zwei Teile aufweisen, die nach Art zweier Deckel beziehungsweise eines Hohlkörpers mit einem Deckel zusammenarbeiten.

Die verschiedenen Teile können getrennt voneinander und zusammensteckbar oder allgemein aneinander befestigbar ausgeführt sein oder verdrehbar, verschiebbar oder klappbar aneinander angeschlossen sein, beispielsweise mittels eines Filmscharniers. Somit kann das Kabel wenigstens teilweise oder vollständig zwischen den verschiedenen Teilen nach dem Zusammenfügen und/oder Zusammenklappen derselben eingeschlossen werden, insbesondere zwischen den Teilen verklemmt werden.

Die verschiedenen Teile werden insbesondere mittels eines Rastverschlusses oder Klippverschlusses miteinander verbunden. Durch das Verbinden beziehungsweise Zusammenklappen der verschiedenen Teile kann vorteilhaft gleichzeitig eine Zentrierung der miteinander zu kontaktierenden Bauteile und/oder eine Verpressung derselben stattfinden.

Die Erfindung ist insbesondere zur Verbindung von Kabeln und MIDs in einem Automobil verwendbar. Beispielsweise kann eine Türbeleuchtung durch Leuchtdioden auf einem dreidimensionalen Schaltungsträger (MID) ausgebildet werden, wobei die Leuchtdioden elektrisch leitend an einem Kabel durch die erfindungsgemäße Verbindung verbunden werden. Ein anderes Anwendungsbeispiel betrifft die Ausbildung eines Fahrzeugschlüssels mit einer Sendeeinheit zum Fernentriegeln und -verschließen einer Kraftfahrzeugtüre.

Die Erfindung soll nachfolgend anhand eines Ausführungsbeispiels einer erfindungsgemäß hergestellten Baugruppe exemplarisch erläutert werden.

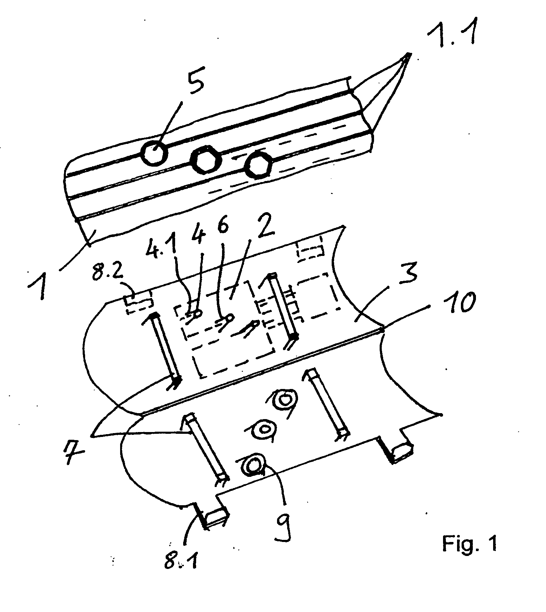

Die Figur 1 zeigt ein Kabel 1 mit drei elektrischen Leitern 1.1, in welchem drei Aussparungen 5 derart ausgestanzt sind, dass jeweils zwei Leiterenden eines Leiters 1.1 in der Ausstanzung münden. Die Ausstanzungen bilden durchgehende Öffnungen in dem Leiter 1 aus und sind im Querschnitt sechseckig ausgeführt. Selbstverständlich kann eine andere Anzahl von Leitern 1.1 und/oder Ausstanzungen 5 vorgesehen sein, und die Aussparungen 5 können insbesondere derart in das Kabel 1 eingebracht sein, dass ein Leiter 1.1 jeweils mit einem einzigen Leiterende in der Aussparung 5 mündet.

Bei der gezeigten Ausführung sind die Leiter 1.1 nur im Bereich der Aussparungen 5 derart verbreitert, dass sie die Aussparung 5 jeweils vollständig umschließen, während sie auf ihrer übrigen Länge außerhalb des Bereichs der Aussparungen 5 eine verminderte Breite aufweisen, die kleiner als die Breite beziehungsweise der Durchmesser der jeweiligen Aussparung 5 in dieser Breitenrichtung ist. Insbesondere wenn die Leiter 1.1 als Flachleiter ausgeführt sind, weisen sie jedoch, wie bei dem untersten in der Figur 1 dargestellten Leiter 1.1 durch die gestrichelten Linien angedeutet ist, vorteilhaft über ihrer gesamten Länge eine, insbesondere konstante, Breite auf, die größer ist als die Ausdehnung der jeweiligen dem Leiter 1.1 zugeordneten Aussparung 5 in dieser Breitenrichtung. Ferner ist in der Figur 1 ein Schaltungsträger 3 dargestellt, welcher eine elektrische oder elektronische Schaltung 2 aufweist. Bei dem Schaltungsträger 3 handelt es sich um ein sogenanntes MID, das heißt einen dreidimensionalen spritzgegossenen Schaltungsträger, welcher mechanische und elektrische Funktionen integriert.

Der Schaltungsträger 3 weist eine konkave Oberfläche auf, auf welcher für die drei Aussparungen 5 in dem Kabel 1 entsprechend drei Kontaktelemente 4 mit einer erhabenen, metallisierten Oberfläche 4.1 ausgebildet sind. Die Kontaktelemente 4 sind in Längsrichtung des Schaltungsträgers 3 und in Längsrichtung des Kabels 1 im eingelegten Zustand und gleichzeitig über der Breitenrichtung des Kabels 1 derart versetzt zueinander angeordnet, dass sie insbesondere diagonal miteinander fluchten. Hierdurch wird erreicht, dass keine Schwächung des Kabels 1 durch zu dicht beieinander vorgesehene Aussparungen 5 erzeugt wird.

Die Kontaktelemente 4 weisen eine kegelförmige Oberfläche und somit eine Auflaufschräge 6 aus, um beim Aufsetzen des Kabels 1 mit seinen Aussparungen 5 darauf eine zunehmende Pressung mit zunehmender Durchdringung der Aussparungen 5 durch die Kontaktelementen 4 zwischen den sich berührenden Oberflächen der Leiter 1.1 und des metallisierten Bereiches der Kontaktelemente 4 zu erzeugen. Dementsprechend sind die Kontaktelemente 4 in ihrem Durchmesser derart ausgeführt, dass sie an ihrem ferngelegenen (freien) Ende einen Durchmesser aufweisen, welcher kleiner als der Durchmesser einer Aussparung 5 ist, und an ihrem mit dem Schaltungsträger 3 verbundenen Ende einen Durchmesser, welcher größer ist als der Innendurchmesser der Aussparungen 5. Die Aussparungen 5 hingegen weisen über der gesamten Dicke des Kabels 1 einen konstanten Querschnitt auf, es wäre jedoch auch denkbar, die Aussparungen 5 mit einem sich verjüngenden Querschnitt zu versehen, um beim Aufschieben innerhalb von einem im Vergleich kürzeren Weg zu dem gewünschten Presssitz zu gelangen.

Der Schaltungsträger 3 ist zweiteilig ausgebildet, wobei die beiden Teile mittels eines Filmscharniers 10 klappbar aneinander befestigt sind. An seinen fern zueinander gelegenen Enden weist der Schaltungsträger 3 einerseits Greifvorsprünge 8.1 und andererseits komplementär ausgebildete Rastaussparungen 8.2 auf, um nach dem Zusammenklappen der beiden Teile über dem Filmscharnier 10 die beiden Teile in einer Rastverbindung aneinander zu befestigen.

Der Schaltungsträger 3 weist zwei konkave Oberflächen auf, welche im geschlossenen Zustand einen im Querschnitt kreisförmigen oder elliptischen Hohlraum umschließen. Auf der ersten konkaven Oberfläche sind die Kontaktelemente 4 angeordnet, und auf der zweiten, der ersten konkaven Oberfläche im geschlossenen Zustand des Schaltungsträgers 3 entgegengesetzten Oberfläche sind Vorsprünge 9 vorgesehen, die Öffnungen umschließen, in welche beim Zusammenklappen der beiden Teile des Schaltungsträgers 3 die Kontaktelemente 4 eintauchen. Selbstverständlich ist es auch möglich, die Öffnungen unmittelbar in der Oberfläche des Schaltungsträgers 3 ohne das Vorsehen entsprechender Vorsprünge auszubilden, wenn der Querschnitt des Schaltungsträgers 3 eine entsprechende Dicke und/oder Form aufweist.

Ferner sind an den beiden in Richtung zueinander klappbaren konkaven Oberflächen des Schaltungsträgers 3 vorstehende Stege angeordnet, welche als ein Verbindungselement 7 zum form- und kraftschlüssigen Befestigen des Kabels 1 an dem Schaltungsträgers 3 zusammenarbeiten. Wenn das Kabel 1 in den Schaltungsträger 3 eingelegt wird und der Schaltungsträger 3 zusammengeklappt wird, schließen die Stege als Verbindungselement 7 das Kabel 1 über seinem gesamten Umfang zwischen sich ein und üben einen Flächendruck auf dieses aus.

Gleichzeitig wird durch das Eintauchen der Kontaktelemente 4 in die Öffnungen der Vorsprünge 9 das Kabel 1 mit seinen Aussparungen 5 tief auf die Kontaktelemente 4 geschoben, so dass ein gewünschter Presssitz zwischen dem Kabel 1 und den Kontaktelementen 4 ausgebildet wird.

Selbstverständlich ist es möglich, andere Formen des Schaltungsträgers 3 und/oder des Kabels 1 vorzusehen, um die erfindungsgemäße Verbindung herzustellen.

## Patentansprüche

1. Verfahren zum Herstellen einer elektrischen Verbindung zwischen einem Kabel (1) mit einem oder einer Vielzahl von elektrischen Leitern (1.1) und einer Schaltung (2) auf einem dreidimensionalen Schaltungsträger (3),
- wobei auf dem Schaltungsträger (3) ein Kontaktelement (4) ausgebildet wird, welches eine erhabene, metallisierte Oberfläche (4.1) aufweist, die mit der Schaltung (2) elektrisch verbunden ist,
- wobei in dem Kabel (1) eine Aussparung (5) in Form eines Durchgangsloches vorgesehen wird, wobei
- die Aussparung (5) derart in das Kabel (1) eingebracht wird, dass sie wenigstens einen Leiter (1.1) in dem Kabel (1) vollständig durchdringt und **dadurch** eine leitende Oberfläche des Leiters (1.1) freilegt, und wobei
- das Kabel (1) derart mit seiner Aussparung (5) auf das Kontaktelement (4) geschoben wird, dass die freigelegte leitende Oberfläche des Leiters (1.1) in einen elektrisch leitenden Kontakt mit der metallisierten Oberfläche (4.1) des Kontaktelementes (4) gelangt.

2. Verfahren gemäß Anspruch 1, **dadurch gekennzeichnet, dass** die Aussparung (5) derart in das Kabel (1) eingebracht wird, dass sie entlang ihres gesamten äußeren Umfangs von der freigelegten leitenden Oberfläche des Leiters (1.1) umschlossen wird, wobei der Leiter (1.1) insbesondere als Flachleiter mit einer Breite ausgebildet wird, die in Richtung eines Durchmessers der Aussparung (5) größer als dieser Durchmesser ist.

3. Verfahren gemäß Anspruch 1 oder 2, **dadurch gekennzeichnet, dass** ein Presssitz zwischen der freigelegten Oberfläche des Leiters (1.1) und der metallisierten Oberfläche (4.1) des Kontaktelementes (4) hergestellt wird, wobei gegebenenfalls der Presssitz mit einer solchen Presskraft hergestellt wird, dass eine Kaltverschweißung zwischen der freigelegten Oberfläche des Leiters (1.1) und der metallisierten Oberfläche (4.1) des Kontaktelementes (4) erzeugt wird.

4. Verfahren gemäß einem der Ansprüche 1 bis 3, **dadurch gekennzeichnet, dass** die Aussparung (5) und/oder das Kontaktelement (4) mit wenigstens einer Auflaufschräge (6) versehen wird, die eine Zentrierung zwischen der freigelegten Oberfläche des Leiters (1.1) und einem vorgegebenen Kontaktbereich der metallisierten Oberfläche (4.1) des Kontaktelementes (4) beim Aufschieben des Kabels (1) auf das Kontaktelement (4) bewirkt.

5. Verfahren gemäß Anspruch 3 oder 4, **dadurch gekennzeichnet,**
**dass** die wenigstens eine Auflaufschräge (6) den vorgegebenen Kontaktbereich der metallisierten Oberfläche (4.1) und/oder die freigelegte Oberfläche des Leiters (1.1) trägt, so dass mit zunehmendem Aufschieben der Presssitz auf der Auflaufschräge (6) erzeugt wird.

6. Verfahren gemäß einem der Ansprüche 1 bis 5, **dadurch gekennzeichnet,**
**dass** das Kontaktelement (4) kegelförmig ausgebildet wird, und die Aussparung (5) teilweise oder vollständig kreisrund ausgebildet wird und/oder,
**dass** das Kontaktelement (4) pyramidenförmig oder eckig und in Richtung ihres oberen Endes verjüngt ausgebildet wird, und die Aussparung (5) teilweise oder vollständig kreisrund ausgebildet wird und/oder dass das Kontaktelement (4) kegelförmig ausgebildet wird, und die Aussparung (5) im Querschnitt, welcher das Kontaktelement (4) aufnimmt, eckig ausgebildet wird.

7. Verfahren gemäß einem der Ansprüche 1 bis 6, **dadurch gekennzeichnet,**
**dass** auf dem Schaltungsträger (3) eine Vielzahl von Kontaktelementen (4) ausgebildet wird, wobei die Kontaktelemente (4) gemeinsam in eine einzige Aussparung (5) des Kabels (1) oder einzeln oder gruppenweise in eine Vielzahl von in dem Kabel (1) entsprechend vorgesehenen Aussparungen (5) geschoben werden, und die Kontaktelemente (4) in Längsrichtung und/oder Breitenrichtung des Kabels (1) versetzt zueinander angeordnet werden, wobei insbesondere pro zu verbindendem Leiter (1.1) des Kabels (1) jeweils eine Aussparung (5) und ein Kontaktelement (4) vorgesehen werden und/oder
**dass** an dem Schaltungsträger (3) wenigstens ein zusätzliches Verbindungselement (7) ausgebildet wird, mittels welchem das Kabel (1) form- und/oder kraftschlüssig am Schaltungsträger (3) befestigt wird.

8. Verfahren gemäß einem der Ansprüche 1 bis 7, **dadurch gekennzeichnet,**
**dass** der Schaltungsträger (3) mehrteilig ausgebildet wird, wobei die einzelnen Teile insbesondere gelenkig und/oder verschiebbar aneinander angeschlossen sind, und dass das Kabel (1) durch wenigstens ein teilweises Einschließen zwischen den verschiedenen Teilen des Schaltungsträgers (3) an diesem befestigt wird, wobei gegebenenfalls durch das Zusammensetzen oder das Zusammenklappen der verschiedenen Teile des Schaltungsträgers (3), um das Kabel (1) einzuschließen, zugleich das Kontaktelement (4) und die Aussparung (5) zueinander zentriert werden.

9. Baugruppe, umfassend einen dreidimensionalen Schaltungsträger (3) mit einer Schaltung (2) und ein Kabel (1) mit einem oder einer Vielzahl von elektrischen Leitern (1.1), **dadurch gekennzeichnet, dass**
- der Schaltungsträger (3) wenigstens ein Kontaktelement (4) umfasst, welches eine erhabene, metallisierte Oberfläche (4.1) aufweist, die elektrisch mit der Schaltung (2) verbunden ist,
- das Kabel (1) wenigstens eine Aussparung (5) in Form eines Durchgangsloches aufweist, welche wenigstens einen Leiter (1.1) in dem Kabel (1) vollständig durchdringt und **dadurch** eine leitende Oberfläche des Leiters (1.1) freilegt, und
- das Kabel (1) mit seiner Aussparung (5) derart auf das Kontaktelement (4) gesetzt ist, dass die freigelegte leitende Oberfläche des Leiters (1.1) in einem elektrisch leitenden Kontakt mit der metallisierten Oberfläche (4.1) des Kontaktelementes (4) steht.

10. Baugruppe gemäß Anspruch 9, **dadurch gekennzeichnet, dass** die Aussparung (5) derart in dem Kabel (1) eingebracht ist, dass sie entlang ihres gesamten äußeren Umfangs von der freigelegten leitenden Oberfläche des Leiters (1.1) umschlossen ist, wobei der Leiter (1.1) insbesondere als Flachleiter mit einer Breite ausgebildet ist, die in Richtung eines Durchmessers der Aussparung (5) größer als dieser Durchmesser ist.

11. Baugruppe gemäß Anspruch 9 oder 10, **dadurch gekennzeichnet,**
- **dass** ein Presssitz zwischen der freigelegten Oberfläche des Leiters (1.1) und der metallisierten Oberfläche (4.1) ausgeführt ist und/oder
- **dass** der Leiter (1.1) und die metallisierte Oberfläche (4.1) miteinander kaltverschweißt sind.

12. Baugruppe gemäß einem der Ansprüche 14 bis 17, **dadurch gekennzeichnet,**
- **dass** das Kabel (1) zusätzlich außerhalb der elektrisch leitenden Verbindung form- und/oder kraftschlüssig mit dem Schaltungsträger (3) verbunden, insbesondere wenigstens teilweise oder vollständig von diesem umschlossen, ist, wobei gegebenenfalls der Schaltungsträger (3) mehrteilig ausgebildet ist, wobei die mehreren Teile insbesondere gelenkig aneinander angeschlossen und durch eine Rastverbindung aneinander befestigt oder befestigbar sind, und das Kabel (1) teilweise oder vollständig zwischen den mehreren Teilen des Schaltungsträgers (3) form- und/oder kraftschlüssig eingeschlossen ist.
